# EUROPEAN PATENT SPECIFICATION

(11) **EP 4 495 730 B1**
(45) Date of publication and mention of the grant of the patent: **12.08.2026**
(21) Application number: 24735848.4
(22) Date of filing: 31.05.2024
(51) Int. Cl.: G06F 1/04, H03L 1/00, G06F 1/06, G06F 1/08, H03B 5/36

(54) **ELECTRONIC DEVICE FOR CONTROLLING CRYSTAL OSCILLATOR AND OPERATION METHOD OF ELECTRONIC DEVICE**
ELEKTRONISCHE VORRICHTUNG ZUR STEUERUNG EINES KRISTALLOSZILLATORS UND VERFAHREN ZUM BETRIEB DAVON
DISPOSITIF ÉLECTRONIQUE DE COMMANDE D'OSCILLATEUR À QUARTZ ET PROCÉDÉ DE FONCTIONNEMENT DE DISPOSITIF ÉLECTRONIQUE

(30) Priority: 07.06.2023 KR 20230073146; 21.06.2023 KR 20230079719
(43) Date of publication of application: 22.01.2025
(73) Proprietor: SAMSUNG ELECTRONICS CO., LTD., Yeongtong-gu Suwon-si, Gyeonggi-do 16677 (KR)
(72) Inventor: KIM, Jungjoon, Suwon-si, Gyeonggi-do 16677 (KR); YOON, Kyoungsik, Suwon-si, Gyeonggi-do 16677 (KR); JANG, Kyujae, Suwon-si, Gyeonggi-do 16677 (KR); JO, Daeyoung, Suwon-si, Gyeonggi-do 16677 (KR); JU, Hyoungyong, Suwon-si, Gyeonggi-do 16677 (KR)
(74) Representative: Arnold & Siedsma
(86) International application number: PCT/KR2024/007508
(87) International publication number: WO 2024/253392

(56) References cited:
- CN-A- 111 030 637
- KR-A- 20200 073 630
- KR-B1- 102 516 356
- US-A1- 2011 075 778
- US-A1- 2014 253 255
- US-A1- 2017 201 281
- US-A1- 2017 373 638

## Description

### [Technical Field]

Various embodiments of the present disclosure relate to an electronic device and a method of operating the same, and more particularly, to an electronic device for controlling a crystal oscillator.

### [Background Art]

In order to meet the demand for wireless data traffic that has increased since the deployment of 4G communication systems, efforts have been made to develop improved 5G or pre-5G communication systems. Therefore, the 5G or pre-5G communication system is called a 'Beyond 4G Network' communication system or a 'Post LTE' system. In order to achieve a high data transmission rate, the 5G communication system is considered to be implemented in an ultrahigh-frequency (mmWave) band (e.g., a band of 6 GHz or higher) in addition to a band (band of 6 GHz or lower) that has been used by LTE. In the 5G communication system, technologies of beamforming, massive MIMO, full dimensional MIMO (FD-MIMO), array antennas, analog beam-forming, and a large-scale antenna (large scale antenna) technology are being discussed.

In order to perform wireless communication, an electronic device may transmit and/or receive signals in frequency bands supported by the wireless communication. In order to transmit signals in frequency bands supported by wireless communication, the electronic device may generate a clock signal having a reference frequency included in a frequency band and change a frequency of a signal in a baseband to a frequency supported by the wireless communication by using the clock signal. In order to generate the clock signal having the reference frequency, the electronic device may apply a drive level to a crystal oscillator (hereinafter, defined as an 'XO') and generate the clock signal having the reference frequency by means of vibration of the crystal oscillator to which the drive level is applied. US 2011/075778 Al discloses a mobile device in which multiple communication modules share a common clock source, wherein one module controls the clock source and coordinates with other modules to adjust oscillator parameters.

### [Disclosure of Invention]

### [Technical Problem]

The XO may generate a clock signal having a frequency different from an intended frequency because of a deviation during a production process. In order to reduce an error in the clock signal generated by the XO, the electronic device may correct a frequency of the clock signal by using a capacitor electrically connected to the XO. Specifically, the electronic device may correct the frequency of the clock signal by determining, during the process of producing the electronic device, an XO trim, which indicates a capacitance value of the capacitor that allows the clock signal to have an accurate reference frequency, and controlling the capacitor so that the capacitor has the determined capacitance.

The XO trim may be determined to include a frequency error that occurs additionally when a drive level, which may be applied to operate the XO, is applied to the XO. The electronic device may use a single trim to correct a frequency of a signal generated by the XO.

In case that a range of frequency bands of communication methods supported by the electronic device is small, an error in the clock signal may not be great even though the single trim is used to correct the frequency of the clock signal generated by the XO. However, in case that a difference between the frequency bands of the communication methods supported by the electronic device is large, optimized drive levels may be different. A frequency error caused by the difference makes it difficult to use a trim value suitable for the optimized drive level in case that the single trim is used to correct the frequency of the clock signal generated by the XO. Because the recent electronic devices support communication methods in various frequency bands, the deviation between the drive levels applied to the XO may increase. In addition, in case that the single trim is used to correct the clock signal, it may not reduce an error in the clock signal that occurs when a drive level, which is different in magnitude from the drive level applied to determine the trim, is applied to the XO.

In case that the single trim is used to correct the clock signal, the electronic device needs to apply a drive level, which is identical to the drive level applied to the XO, to the XO to generate the trim to reduce an error in the clock signal. As described above, because the trim is generated by applying a drive level, which is highest among the drive levels that may be applied to the XO, to the XO, the durability of the XO may deteriorate because of the drive level applied to the XO.

Technical problems to be solved by the present document are not limited to the above-mentioned technical problems, and other technical problems, which are not mentioned above, may be clearly understood from the following descriptions by those skilled in the art to which the present disclosure pertains.

### [Solution to Problem]

The present invention provides an electronic device according to claim 1, and a method according to claim 10. In particular, the electronic device includes a processor. The electronic device includes a clock generation circuit including a crystal oscillator (XO) configured to generate a clock signal having at least one of a plurality of reference frequencies. The electronic device includes a memory configured to store mapping data in which correction values used to correct the reference frequency of the clock signal are mapped to each of drive levels for controlling a drive level to be applied to the XO and another mapping data including different correction values in accordance with a communication method used by the electronic device. The processor selects the drive level to be applied to the XO corresponding to a frequency band of a communication method used by the electronic device. The processor selects one of the correction values based on the selected drivel level based on the mapping data and the other mapping data. The processor is configured to control the clock generation circuit to correct the reference frequency of the clock signal by using the selected correction value.

The method of operating an electronic device includes determining a drive level to be applied to a crystal oscillator (XO) configured to generate a clock signal having at least one of a plurality of reference frequencies corresponding to a frequency band of a communication method used by the electronic device. The method of operating the electronic device includes selecting a correction value that corresponds with the determined drive level based on mapping data in which correction values used to correct the reference frequency of the clock signal are mapped to each of drive levels to be applied to the XO and based on another mapping data including different correction values in accordance with the communication method used by the electronic device. The method of operating the electronic device includes correcting the reference frequency of the clock signal by using the selected correction value.

### [Advantageous Effects of Invention]

The electronic device and the method of operating the same according to the embodiment may correct the clock signal, which is generated by the XO, by using the plurality of mapping data made by mapping the correction value used to correct the frequency of the clock signal in accordance with the magnitude of the drive level to be applied to the XO. The plurality of mapping data may include different correction values in accordance with the magnitude of the drive level to be applied to the XO, and the electronic device may generate the clock signal having a low error by using the plurality of mapping data, thereby improving the communication performance.

The electronic device and the method of operating the same according to the embodiment may correct the clock signal, which is generated by the XO, by using the plurality of mapping data made by mapping the correction value used to correct the frequency of the clock signal in accordance with the magnitude of the drive level to be applied to the XO. Therefore, the electronic device may increase the lifespan of the XO by reducing the occurrence frequency of the situation in which the highest drive level needs to be applied to the XO in the situation in which the clock signal having the highest reference frequency is not required.

The effects obtained by the present disclosure are not limited to the aforementioned effects, and other effects, which are not mentioned above, will be clearly understood by those skilled in the art from the following description.

### [Brief Description of Drawings]

FIG. 1 is a block diagram of an electronic device according to various embodiments of the present disclosure.
FIG. 2 is a block diagram of the electronic device for supporting legacy network communication and 5G network communication according to various embodiments.
FIG. 3A is a block diagram of an electronic device according to an embodiment.
FIG. 3B is a block diagram illustrating a clock generation circuit of the electronic device according to the embodiment.
FIG. 3C is a view illustrating an error in a reference frequency generated by a crystal oscillator (XO) in accordance with an applied drive level in the electronic device according to the embodiment.
FIG. 4 is a block diagram of an electronic device according to an embodiment.
FIG. 5 is a view illustrating an example in which the clock generation circuit corrects a reference frequency by using a plurality of mapping data in the electronic device according to the embodiment.
FIG. 6 is a flowchart illustrating a method of operating the electronic device according to the embodiment.
FIG. 7 is a flowchart illustrating the method of operating the electronic device according to the embodiment.

### [Mode for the Invention]

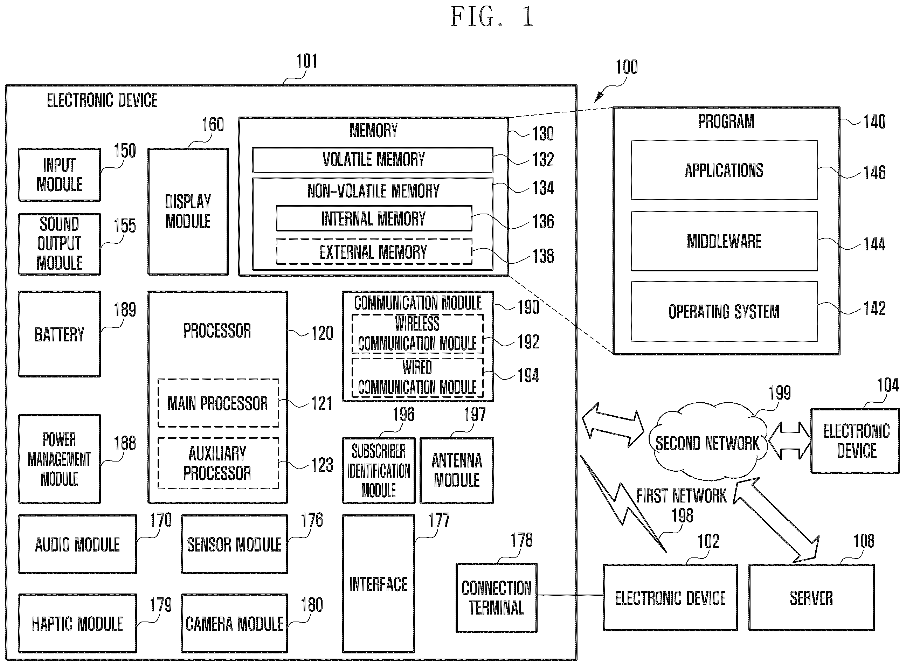

FIG. 1 is a block diagram illustrating an electronic device 101 in a network environment 100 according to certain embodiments. Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input device 150, a sound output device 155, a display device 160, an audio module 170, a sensor module 176, an interface 177, a haptic module 179, a camera module 180, a power management module 188, a battery 189, a communication module 190, a subscriber identification module (SIM) 196, or an antenna module 197. In some embodiments, at least one (e.g., the display device 160 or the camera module 180) of the components may be omitted from the electronic device 101, or one or more other components may be added in the electronic device 101. In some embodiments, some of the components may be implemented as single integrated circuitry. For example, the sensor module 176 (e.g., a fingerprint sensor, an iris sensor, or an illuminance sensor) may be implemented as embedded in the display device 160 (e.g., a display).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140may be stored in the memory 130 as software, and may include, for example, an operating system (OS) 142, middleware 144, or an application 146.

The input device 150 may receive a command or data to be used by other component (e.g., the processor 120) of the electronic device 101, from the outside (e.g., a user) of the electronic device 101. The input device 150 may include, for example, a microphone, a mouse, a keyboard, or a digital pen (e.g., a stylus pen).

The sound output device 155 may output sound signals to the outside of the electronic device 101. The sound output device 155 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display device 160 may visually provide information to the outside (e.g., a user) of the electronic device 101. The display device 160 may include, for example, a display, a hologram device, or a projector and control circuitry to control a corresponding one of the display, hologram device, and projector. According to an embodiment, the display device 160 may include touch circuitry adapted to detect a touch, or sensor circuitry (e.g., a pressure sensor) adapted to measure the intensity of force incurred by the touch.

The audio module 170 may convert a sound into an electrical signal and vice versa. According to an embodiment, the audio module 170 may obtain the sound via the input device 150, or output the sound via the sound output device 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

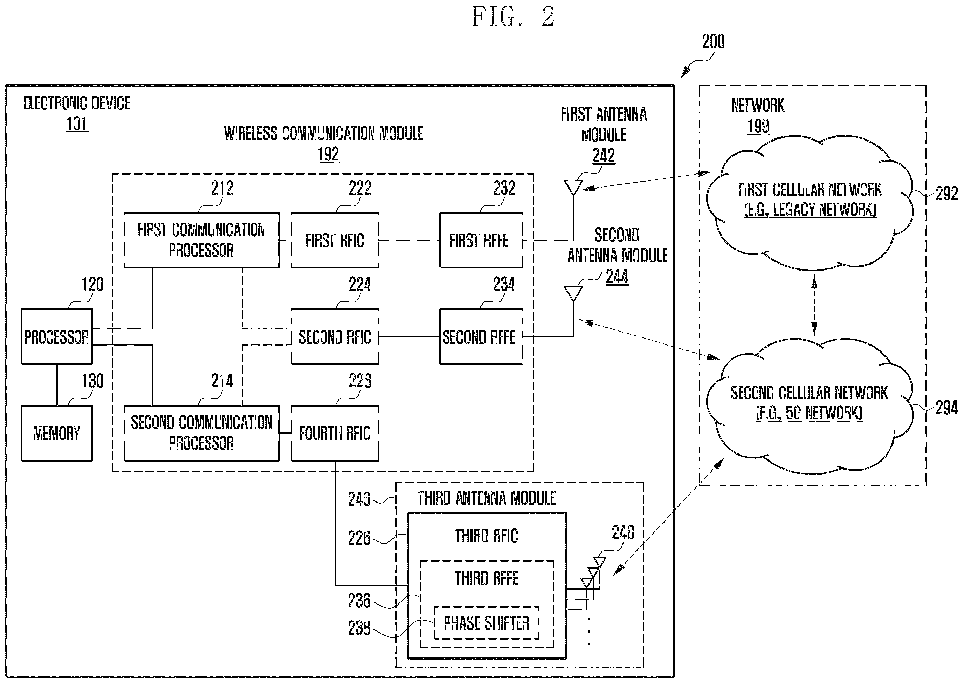

FIG. 2 is a block diagram 200 of an electronic device 101 for supporting legacy network communication and 5G network communication according to certain embodiments. Referring to FIG. 2, the electronic device 101 may include a first communication processor 212, a second communication processor 214, a first radio frequency integrated circuit (RFIC) 222, a second RFIC 224, a third RFIC 226, a fourth RFIC 228, a first radio frequency front end (RFFE) 232, a second RFFE 234, a first antenna module 242, a second antenna module 244, and an antenna 248. The electronic device 101 may further include the processor 120 and the memory 130. The network 199 may include a first network 292 and a second network 294. According to another embodiment, the electronic device 101 may further include at least one component among the components illustrated in FIG. 1, and the network 199 may further include at least one other network. According to an embodiment, the first communication processor 212, the second communication processor 214, the first RFIC 222, the second RFIC 224, the fourth RFIC 228, the first RFFE 232, and the second RFFE 234 may be included as at least a part of the wireless communication module 192. According to another embodiment, the fourth RFIC 228 may be omitted or may be included as a part of the third RFIC 226.

The first communication processor 212 may establish a communication channel of a band to be used for wireless communication with the first network 292, and may support legacy network communication via the established communication channel. According to certain embodiments, the first network may be a legacy network including 2G, 3G, 4G, or long term evolution (LTE) network. The second communication processor 214 may establish a communication channel corresponding to a designated band (e.g., approximately 6GHz to 60 GHz) among bands to be used for wireless communication with the second network 294, and may support 5G network communication via the established channel. According to certain embodiments, the second network 294 may be a 5G network defined in 3GPP. Additionally, according to an embodiment, the first communication processor 212 or the second communication processor 214 may establish a communication channel corresponding to another designated band (e.g., lower than 6GHz) among bands to be used for wireless communication with the second network 294, and may support 5G network communication via the established channel. According to an embodiment, the first communication processor 212 and the second communication processor 214 may be implemented in a single chip or a single package. According to certain embodiments, the first communication processor 212 or the second communication processor 214 may be implemented in a single chip or a single package, together with the processor 120, the sub-processor 123, or the communication module 190.

In the case of transmission, the first RFIC 222 may convert a baseband signal generated by the first communication processor 212 into a radio frequency (RF) signal in a range of approximately 700MHz to 3GHz used for the first network 292 (e.g., a legacy network). In the case of reception, an RF signal is obtained from the first network 292 (e.g., a legacy network) via an antenna (e.g., the first antenna module 242), and may be preprocessed via an RFFE (e.g., the first RFFE 232). The first RFIC 222 may convert the preprocessed RF signal to a baseband signal so that the base band signal is processed by the first communication processor 212.

In the case of transmission, the second RFIC 224 may convert a baseband signal generated by the first communication processor 212 or the second communication processor 214 into an RF signal (hereinafter, a 5G Sub6 RF signal) of a Sub6 band (e.g., lower than 6GHz) used for the second network 294 (e.g., 5G network). In the case of reception, a 5G Sub6 RF signal is obtained from the second network 294 (e.g., a 5G network) via an antenna (e.g., the second antenna module 244), and may preprocessed by an RFFE (e.g., the second RFFE 234). The second RFIC 224 may convert the preprocessed 5G Sub6 RF signal into a baseband signal so that the baseband signal is processed by a corresponding communication processor from among the first communication processor 212 or the second communication processor 214.

The third RFIC 226 may convert a baseband signal generated by the second communication processor 214 into an RF signal (hereinafter, a 5G Above6 RF signal) of a 5G Above6 band (e.g., approximately 6GHz to 60GHz) to be used for the second network 294 (e.g., 5G network). In the case of reception, a 5G Above6 RF signal is obtained from the second network 294 (e.g., a 5G network) via an antenna (e.g., the antenna 248), and may be preprocessed by the third RFFE 236. The third RFIC 226 may convert the preprocessed 5G Above6 RF signal to a baseband signal so that the base band signal is processed by the second communication processor 214. According to an embodiment, the third RFFE 236 may be implemented as a part of the third RFIC 226.

According to an embodiment, the electronic device 101 may include the fourth RFIC 228, separately from or as a part of the third RFIC 226. In this instance, the fourth RFIC 228 may convert a baseband signal generated by the second communication processor 214 into an RF signal (hereinafter, an IF signal) in an intermediate frequency band (e.g., approximately 9GHz to 11GHz), and may transfer the IF signal to the third RFIC 226. The third RFIC 226 may convert the IF signal to a 5G Above6 RF signal. In the case of reception, a 5G Above6 RF signal is received from the second network 294 (e.g., a 5G network) via an antenna (e.g., the antenna 248), and may be converted into an IF signal by the third RFFE 226. The fourth RFIC 228 may convert the IF signal to a baseband signal so that the base band signal is processed by the second communication processor 214.

According to an embodiment, the first RFIC 222 and the second RFIC 224 may be implemented as a single chip or at least a part of the single package. According to an embodiment, the first RFFE 232 and the second RFFE 234 may be implemented as a single chip or at least a part of the single package. According to an embodiment, at least one antenna module of the first antenna module 242 or the second antenna module 244 may be omitted, or may be combined with another antenna module so as to process RF signals in a plurality of bands.

According to an embodiment, the third RFIC 226 and the antenna 248 may be disposed in the same substrate, and may form the third antenna module 246. For example, the wireless communication module 192 or the processor 120 may be disposed in a first substrate (e.g., main PCB). In this instance, the third RFIC 226 is disposed in a part (e.g., a lower part) of the second substrate (e.g., a sub PCB) separate from the first substrate and the antenna 248 is disposed on another part (e.g., an upper part), so that the third antenna module 246 is formed. By disposing the third RFIC 226 and the antenna 248 in the same substrate, the length of a transmission line therebetween may be reduced. For example, this may reduce a loss (e.g., attenuation) of a signal in a high-frequency band (e.g., approximate 6GHz to 60GHz) used for 5G network communication, the loss being caused by a transmission line. Accordingly, the electronic device 101 may improve the quality or speed of communication with the second network 294 (e.g., 5G network).

According to an embodiment, the antenna 248 may be implemented as an antenna array including a plurality of antenna elements which may be used for beamforming. In this instance, the third RFIC 226 may be, for example, a part of the third RFFE 236, and may include a plurality of phase shifters 238 corresponding to a plurality of antenna elements. In the case of transmission, each of the plurality of phase shifters 238 may shift the phase of a 5G Above6RF signal to be transmitted to the outside of the electronic device 101 (e.g., a base station of a 5G network) via a corresponding antenna element. In the case of reception, each of the plurality of phase shifters 238 may shift the phase of the 5G Above6 RF signal received from the outside via a corresponding antenna element into the same or substantially the same phase. This may enable transmission or reception via beamforming between the electronic device 101 and the outside.

The second network 294 (e.g., 5G network) may operate independently (e.g., Stand-Along (SA)) from the first network 292 (e.g., a legacy network), or may operate by being connected thereto (e.g., Non-Stand Alone (NSA)). For example, in the 5G network, only an access network (e.g., 5G radio access network (RAN) or next generation RAN (NG RAN)) may exist, and a core network (e.g., next generation core (NGC)) may not exist. In this instance, the electronic device 101 may access an access network of the 5G network, and may access an external network (e.g., the Internet) under the control of the core network (e.g., an evolved packed core (EPC)) of the legacy network. Protocol information (e.g., LTE protocol information) for communication with the legacy network or protocol information (e.g., New Radio (NR) protocol information) for communication with the 5G network may be stored in the memory 230, and may be accessed by another component (e.g., the processor 120, the first communication processor 212, or the second communication processor 214).

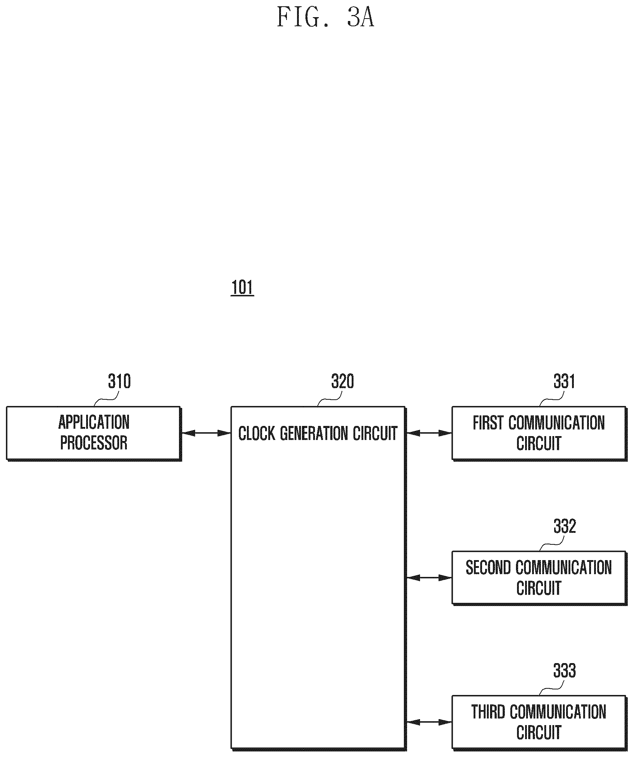

FIG. 3A is a block diagram of an electronic device according to the embodiment.

An electronic device (e.g., the electronic device 101 in FIG. 1) may include an application processor 310 (e.g., the processor 120 in FIG. 1), a clock generation circuit 320, a first communication circuit 331, a second communication circuit 332, and/or a third communication circuit 333.

The electronic device 101 may support various communication methods of transmitting and/or receiving signals in various frequency bands. According to the embodiment, the electronic device 101 may support a first communication method for transmitting and/or receiving data by using a signal in a first frequency band, a second communication method for transmitting and/or receiving data by using a signal in a second frequency band, and/or a third communication method for transmitting and/or receiving a signal in a third frequency band.

According to the embodiment, the first communication method may refer to any one communication method among various cellular communication methods, which may be supported by the electronic device 101, e.g., a communication method on the first cellular network 292 in FIG. 2. For example, the first communication method may be a communication method of transmitting and/or receiving data by using the signal in the first frequency band that is a frequency band of 2.6 GHz or lower. The first communication circuit 331 is a communication circuit that supports the first communication method. The first communication circuit 331 may receive the signal in the first frequency band and demodulate the received signal. Alternatively, the first communication circuit 331 may modulate a signal in a baseband, which is transmitted by a communication processor (e.g., the first communication processor 212 or the second communication processor 214 in FIG. 2), to the first frequency band.

According to the embodiment, the second communication method may refer to any one communication method among various cellular communication methods, which may be supported by the electronic device 101, e.g., a communication method on the second cellular network 294 in FIG. 2. For example, the second communication method may be a communication method of transmitting and/or receiving data by using the signal in the second frequency band that is a frequency band of 6 GHz or higher or an ultrahigh-frequency (e.g., 28 GHz) band. The second communication circuit 332 is a communication circuit that supports the second communication method. The second communication circuit 332 may receive the signal in the second frequency band and demodulate the received signal. Alternatively, the second communication circuit 332 may modulate the signal in the baseband, which is transmitted by the communication processor (e.g., the first communication processor 212 or the second communication processor 214 in FIG. 2), to the second frequency band. FIG. 3A illustrates that the first communication circuit 331 and the second communication circuit 332 are implemented as separate components. However, the first communication circuit 331 and the second communication circuit 332 may be integrated into a single component.

According to the embodiment, the third communication method may refer to any one communication method among near-field communications, which may be supported by the electronic device 101. For example, the third communication method may refer to a Wi-Fi method defined by IEEE 802.11. For example, the third communication method may be a communication method of transmitting and/or receiving data by using the signal in the third frequency band that is a frequency band of 2.4 GHz or 6 GHz. The third communication circuit 333 is a communication circuit that supports the third communication method. The third communication circuit 333 may receive the signal in the third frequency band and demodulate the received signal. Alternatively, the third communication circuit 333 may modulate a signal, which includes data transmitted by the application processor 331, to the third frequency band.

The first communication circuit 331, the second communication circuit 332, and/or the third communication circuit 333 may require clock signals (or reference signals) having reference frequencies of the communication methods to modulate the signals in the baseband or demodulate the signals received from the outside. The application processor 310 may control the clock generation circuit 320 to provide the clock signals required for operations of the first communication circuit 331, the second communication circuit 332, and/or the third communication circuit 333.

The clock generation circuit 320 may generate and provide the clock signal having the reference frequency required for the operation of the communication circuit under the control of the application processor 310.

According to the embodiment, in response to receiving a control signal (e.g., a control signal for generating a first reference frequency included in the first frequency band) of the application processor 310, the clock generation circuit 320 may generate the clock signal having the first reference frequency and transmit the clock signal having the first reference frequency to the first communication circuit 331.

According to the embodiment, in response to receiving a control signal (e.g., a control signal for generating a second reference frequency included in the second frequency band) of the application processor 310, the clock generation circuit 320 may generate the clock signal having the second reference frequency and transmit the clock signal having the second reference frequency to the second communication circuit 332.

According to the embodiment, in response to receiving a control signal (e.g., a control signal for generating a third reference frequency included in the third frequency band) of the application processor 310, the clock generation circuit 320 may generate the clock signal having the third reference frequency and transmit the clock signal having the third reference frequency to the third communication circuit 333.

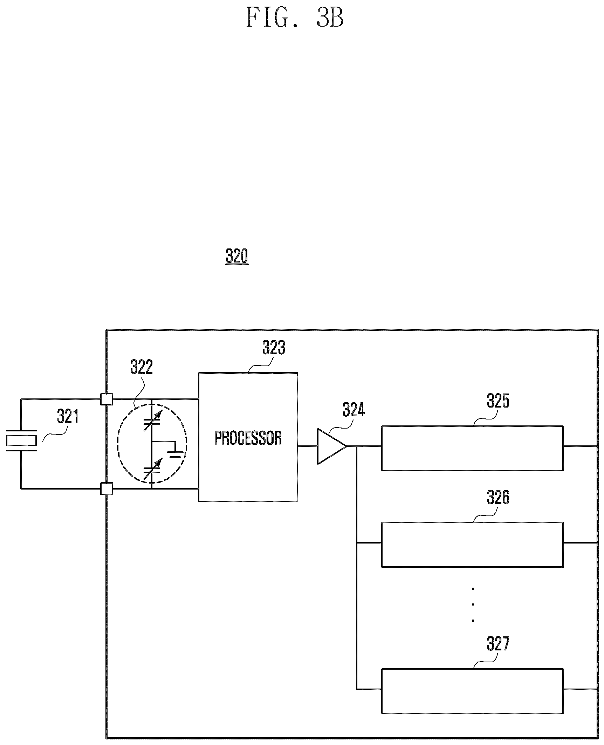

A specific configuration for generating the clock signal having the reference frequency will be described below with reference to FIG. 3B.

FIG. 3B is a block diagram illustrating the clock generation circuit of the electronic device according to the embodiment.

The clock generation circuit (e.g., the clock generation circuit 320 in FIG. 3A) may include an XO 321, at least one capacitor 322, a processor 323, an amplifier 324, and a plurality of frequency change circuits 325, 326, and 327.

The XO 321 may include a crystal element that vibrates at a particular frequency corresponding to a magnitude of a drive level in accordance with a magnitude of a drive level applied by the processor 323. The reference signal may be generated by means of the vibration of the crystal element. The crystal element may change the frequency band related to the vibration of the crystal element depending on the magnitude of the drive level. For example, as the magnitude of the applied drive level increases, the crystal element may greatly vibrate and generate a reference signal having a higher reference frequency.

The processor 323 may generate the clock signal having the reference frequency by applying the drive level, which corresponds to the reference frequency of the clock signal to be generated by the clock generation circuit 320, to the XO 321. However, the XO 321 may generate a clock signal having a frequency different from an accurate reference frequency because of a deviation occurring during a process of producing the XO 321. A difference between the accurate reference frequency and the frequency different from the accurate reference frequency may be defined as a DC frequency error. In order to reduce the error (or generate the clock signal having the accurate reference frequency), the processor 323 may compensate for the clock signal by using the capacitor 322. Specifically, the processor 323 may determine a capacitance of the capacitor 322 that allows the clock signal to have the accurate reference frequency, and the processor 323 may control the capacitor 322 so that the capacitor 322 has the determined capacitance.

The processor 323 may acquire the clock signal having the accurate reference frequency by controlling the capacitor 322. The acquired clock signal may be amplified by the amplifier 324 and transmitted to at least one frequency change circuit among the plurality of frequency change circuits 325, 326, and 327.

The plurality of frequency change circuits 325, 326, and 327 may be electrically connected to the communication circuits (e.g., the first communication circuit 331, the second communication circuit 332, and the third communication circuit 333 in FIG. 3A). The plurality of frequency change circuits 325, 326, and 327 may process the clock signals so that the clock signals have the reference frequencies required for the communication circuits electrically connected to the plurality of frequency change circuits 325, 326, and 327.

According to the embodiment, the plurality of frequency change circuits 325, 326, and 327 may include various components capable of changing the frequencies of the clock signals. The first frequency change circuit 325 may convert the clock signal having the reference frequency into the clock signal having the first reference frequency required for the operation of the first communication circuit 331. The second frequency change circuit 326 may convert the clock signal having the reference frequency into the clock signal having the second reference frequency required for the operation of the second communication circuit 332. The third frequency change circuit 327 may convert the clock signal having the reference frequency into the clock signal having the third reference frequency required for the operation of the third communication circuit 333.

As described above, the processor 323 may control the capacitor 322 to correct the clock signal having a frequency different from the reference frequency because of a deviation of the XO 321 (or to compensate for the frequency of the clock signal). The capacitance, which allows the capacitor 322 to compensate for the frequency, may be defined as a trim. The electronic device 101 may store the trim in the memory (e.g., the memory 160 in FIG. 1) and control the clock generation circuit 320 to generate the clock signal having the accurate reference frequency by using the trim. The trim may be determined, when the electronic device 101 or the clock generation circuit 320 is manufactured, on the basis of a difference between the reference frequency and a frequency of a signal generated when a particular drive level is applied to the XO 321 at a particular temperature (e.g., at room temperature).

The trim may be determined on the basis of a difference between the reference frequency and a frequency of a signal generated when a drive level, which is highest among the drive levels that may be applied to the XO 321, to the XO 321. The clock generation circuit 320 may use the single trim to correct the frequency of the signal generated by the XO 321.

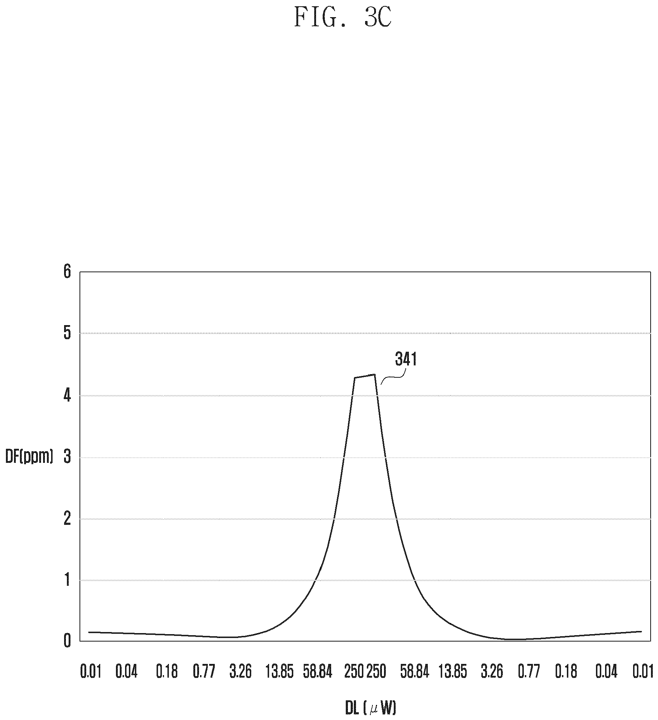

In case that a difference between frequency bands of communication methods supported by the electronic device 101 is small, an error in the clock signal may not be great even though the single trim is used to correct the frequency of the clock signal generated by the XO 321. However, in case that the difference between the frequency bands of the communication methods supported by the electronic device 101 is large, an error in the clock signal may be great in case that the single trim is used to correct the frequency of the clock signal generated by the XO 321. The phenomenon will be described below with reference to FIG. 3C.

FIG. 3C is a view illustrating an error in a reference frequency generated by a crystal oscillator (XO) in accordance with an applied drive level in the electronic device according to the embodiment.

FIG. 3C illustrates an error 341 of a frequency of a clock signal generated by the XO 321 in accordance with a magnitude of a drive level (defined as a drive level) applied to the XO (e.g., the XO 321 in FIG. 3B).

In case that the magnitude of the drive level applied to the XO 321 is relatively small (e.g., the magnitude of the drive level applied to the XO 321 is 3.26 µW or less), there may occur almost no error in the frequency of the clock signal generated by the XO 321. The configuration in which there occurs almost no error in the frequency of the clock signal generated by the XO 321 may mean that the frequency of the clock signal, which is generated by the XO 321, and the reference frequency are substantially equal in magnitude.

However, in case that the magnitude of the drive level applied to the XO 321 gradually increases (e.g., the magnitude of the drive level applied to the XO 321 is 13.85 µW or more), an error in the frequency of the clock signal generated by the XO 321 may gradually increase. When the magnitude of the drive level applied to the XO 321 is a designated value (e.g., 250 µW), an error in the frequency of the clock signal generated by the XO 321 may be largest. In case that the magnitude of the drive level applied to the XO 321 decreases again, an error in the frequency of the clock signal generated by the XO 321 may decrease again.

An error in the frequency of the clock signal generated by the XO 321 in case that the magnitude of the drive level applied to the XO 321 is relatively large may be different from an error in the frequency of the clock signal generated by the XO 321 when the magnitude of the drive level applied to the XO 321 is relatively small. However, in case that the trim, which is constant regardless of the magnitude of the drive level applied to the XO 321, used to correct a clock signal outputted from the XO 321, it may be difficult to generate the clock signal having the accurate reference frequency.

Furthermore, the trim may be determined as a single designated value on the basis of the difference between the reference frequency and the frequency of the signal generated by applying the drive level, which is highest among the drive levels that may be applied to the XO 321, to the XO 321.

In case that the single trim is used to correct the clock signal, the clock generation circuit 320 needs to apply the highest drive level to the XO 321 to generate the clock signal having the accurate reference frequency. In case that the highest drive level is applied to the XO 321, there may occur a problem in that the lifespan of the XO 321 decreases.

In case that the electronic device 101 supports communication methods in similar frequency bands, an error in the clock signal may be reduced even though the single trim is used to correct the clock signal. However, because the recent electronic device 101 supports communication methods in various frequency bands, the deviation of the drive level applied to the XO 321 may increase. In addition, in case that the single trim is used to correct the clock signal, it may not reduce an error in the clock signal that occurs when a drive level, which is different in magnitude from the drive level applied to determine the trim, is applied to the XO 321.

Hereinafter, an example will be described in which a plurality of trims, which is generated by applying drive levels with different magnitudes to the XO 321, is used to correct the clock signal to cope with the above-mentioned phenomenon.

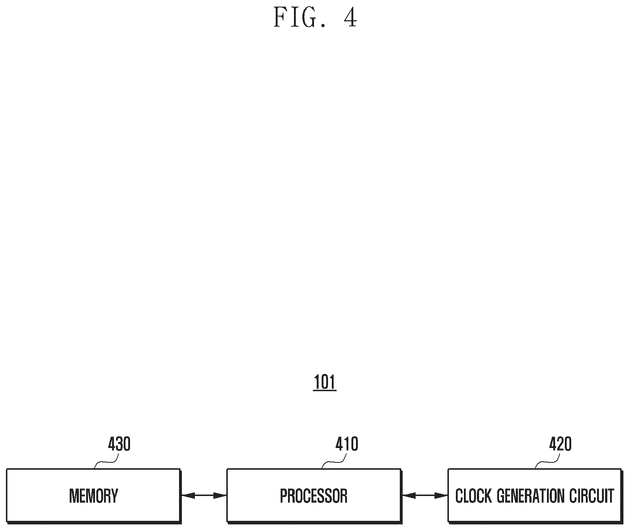

FIG. 4 is a block diagram of an electronic device according to an embodiment.

With reference to FIG. 4, an electronic device (e.g., the electronic device 101 in FIG. 1) may include a processor 410 (e.g., the processor 120 in FIG. 1), a clock generation circuit 420, and/or a memory 430 (e.g., the memory 160 in FIG. 1).

The electronic device 101 may support various communication methods of transmitting and/or receiving signals in various frequency bands. According to the embodiment, the electronic device 101 may support a first communication method for transmitting and/or receiving data by using a signal in a first frequency band, a second communication method for transmitting and/or receiving data by using a signal in a second frequency band, and/or a third communication method for transmitting and/or receiving data by using a signal in a third frequency band.

According to the embodiment, the first communication method may refer to any one communication method among various cellular communication methods, which may be supported by the electronic device 101, e.g., a communication method on the first cellular network 292 in FIG. 2. For example, the first communication method may be a communication method of transmitting and/or receiving data by using the signal in the first frequency band that is a frequency band of 2.6 GHz or lower.

According to the embodiment, the second communication method may refer to any one communication method among various cellular communication methods, which may be supported by the electronic device 101, e.g., a communication method on the second cellular network 294 in FIG. 2. For example, the second communication method may be a communication method of transmitting and/or receiving data by using the signal in the second frequency band that is a frequency band of 6 GHz or higher or an ultrahigh-frequency (e.g., 28 GHz) band.

According to the embodiment, the third communication method may refer to any one communication method among near-field communications, which may be supported by the electronic device 101. For example, the third communication method may refer to a Wi-Fi method defined by IEEE 802.11. For example, the third communication method may be a communication method of transmitting and/or receiving data by using the signal in the third frequency band that is a frequency band of 2.4 GHz or 6 GHz.

The processor 410 may identify the frequency band of the communication method being used by the electronic device 101 and control the clock generation circuit 420 to generate the clock signal having the reference frequency included in the identified frequency band.

According to the embodiment, the processor 410 may identify the frequency band of the communication method, which is being used by the electronic device 101, by receiving information, which indicates the frequency band of the communication method being used by the electronic device 101, from the communication processor (e.g., the first communication processor 212 or the second communication processor 214 in FIG. 2).

According to the embodiment, the processor 410 may identify the frequency band of the communication method, which is being used by the electronic device 101, by receiving information, which indicates the frequency band of the communication method being used by the electronic device 101, from the communication circuit (e.g., the third communication circuit 333 in FIG. 3A) that supports the near field communication.

The processor 410 may determine (or select) the magnitude of the drive level to be applied to the XO (e.g., the XO 321 in FIG. 3B) included in the clock generation circuit 420 on the basis of the identified frequency band. The drive level may refer to the power of the XO 321 consumed while the clock generation circuit 420 operates (or in an activated state). The drive level may be determined on the basis of a magnitude of a voltage or current, which is to be applied to the XO 321, and/or resistance of the XO 321. The determining (or selecting) of the magnitude of the drive level may include determining (or selecting) a control value of the drive level for controlling the magnitude of the drive level to be applied to the XO 321. For example, the processor 410 may determine the magnitude of the drive level, which is to be applied to the XO 321, with reference to data made by mapping the frequency band and the magnitude of the drive level to be applied to the XO 321.

For example, the data made by mapping the frequency band and the magnitude of the drive level to be applied to the XO 321 may be implemented, as shown in Table 1 below. The data made by mapping the frequency band and the magnitude of the drive level, which is to be applied to the XO 321, or the control value for controlling the magnitude of the drive level may be stored in the memory 430.

**[Table 1]**

| Frequency band | Magnitude of drive level to be applied to XO 321 or control value for controlling magnitude of drive level |
|---|---|
| First frequency band | First value (e.g., 10 µW) |
| Third frequency band | Third value (e.g., 100 µW) |
| Second frequency band | Second value (e.g., 250 µW) |

Alternatively, the processor 410 may determine the magnitude of the drive level to be applied to the XO (e.g., the XO 321 in FIG. 3B) included in the clock generation circuit 420 in accordance with the communication method being used by the electronic device 101. For example, the processor 410 may determine the magnitude of the drive level to be applied to the XO 321 with reference to data made by mapping the communication method being used by the electronic device 101 and the magnitude of the drive level to be applied to the XO 321.

For example, the data made by mapping the communication method being used by the electronic device 101 and the magnitude of the drive level to be applied to the XO 321 may be implemented as shown in Table 2 below. The data made by mapping the communication method being used by the electronic device 101 and the magnitude of the drive level applied to the XO 321 may be stored in the memory 430.

**[Table 2]**

| Communication method | Magnitude of drive level to be applied to XO 321 or control value for controlling magnitude of drive level |
|---|---|
| First communication method | First value (e.g., 10 µW) |
| Third communication method | Third value (e.g., 100 µW) |
| Second communication method | Second value (e.g., 250 µW) |

The electronic device 101 corrects the clock signal outputted by the XO 321 by using different trims in accordance with the magnitude of the drive level to be applied to the XO 321, thereby reducing an error in the clock signal and/or reducing the deterioration in lifespan of the XO 321 caused by the consistent application of a high drive level to the XO 321. The electronic device 101 may store, in the memory 430, a plurality of mapping data made by mapping correction values used to correct the reference frequency of the clock signal in accordance with the magnitude of the drive level to be applied to the XO 321.

The plurality of mapping data may include different correction values in accordance with the magnitude of the drive level to be applied to the XO 321. The plurality of mapping data may include first mapping data including correction values used to correct the clock signal in case that the magnitude of the drive level to be applied to the XO 321 is a first value, second mapping data including correction values used to correct the clock signal in case that the magnitude of the drive level to be applied to the XO 321 is a second value, and third mapping data including correction values used to correct the clock signal in case that the magnitude of the drive level to be applied to the XO 321 is a third value. According to the embodiment, the first mapping data may be implemented as shown in Table 3, the second mapping data may be implemented as shown in Table 4, and the third mapping data may be implemented as shown in Table 5.

**[Table 3]**

| Magnitude of drive level to be applied to XO 321 or control value for controlling magnitude of drive level | Trim value |
|---|---|
| First value (e.g., 10 µW) | First correction value |

**[Table 4]**

| Magnitude of drive level to be applied to XO 321 or control value for controlling magnitude of drive level | Trim value |
|---|---|
| Second value (e.g., 250 µW) | Second correction value |

**[Table 5]**

| Magnitude of drive level to be applied to XO 321 or control value for controlling magnitude of drive level | Trim value |
|---|---|
| Third value (e.g., 100 µW) | Third correction value |

The processor 410 may select any one of the plurality of mapping data on the basis of the magnitude of the drive level to be applied to the XO 321.

According to the embodiment, in case that the magnitude of the drive level to be applied to the XO 321 is the first value, the processor 410 may select the first mapping data including the first correction value that is the trim mapped with the first value among the plurality of mapping data.

According to the embodiment, in case that the magnitude of the drive level to be applied to the XO 321 is the second value, the processor 410 may select the second mapping data including the second correction value that is the trim mapped with the second value among the plurality of mapping data.

According to the embodiment, in case that the magnitude of the drive level to be applied to the XO 321 is the third value, the processor 410 may select the third mapping data including the third correction value that is the trim mapped with the third value among the plurality of mapping data.

The example has been described in which the mapping data are implemented by mapping the trim and the magnitude of the drive level to be applied to the XO 321. However, the trim and the communication method used by the electronic device 101 may be mapped. In this case, the plurality of mapping data may be implemented to include different trims (or correction values) in accordance with the communication method used by the electronic device 101. According to the embodiment, the plurality of mapping data may include the first mapping data made by mapping the first communication method and the first correction value, the second mapping data made by mapping the second communication method and the second correction value, and/or the third mapping data made by mapping the third communication method and the third correction value.

The processor 410 may control the clock generation circuit 420 to correct the reference frequency of the clock signal generated by the XO 321 by using the determined correction value with respect to the selected mapping data.

According to the embodiment, in response to detecting activation of the first communication method of transmitting and/or receiving data by using the signal in the first frequency band, the processor 410 may control the clock generation circuit 420 to apply the drive level having the first value to the XO 321. In response to applying the drive level having the first value to the XO 321, the processor 410 may select the first mapping data among the plurality of mapping data and control the clock generation circuit 420 so that the capacitor (e.g., the capacitor 322 in FIG. 3B) has a capacitance equal to the first correction value included in the selected first mapping data. The processor 410 may transform the first correction value to capacitance value of the capacitor 322 and transmit the capacitance value of the capacitor 322 to the clock generation circuit 420. The clock generation circuit 420 may generate the clock signal having the first reference frequency by correcting the clock signal, which is generated by applying the drive level having the first value to the XO 321, by using the capacitor 322 having the capacitance equal to the first correction value.

According to the embodiment, in response to detecting activation of the second communication method of transmitting and/or receiving data by using the signal in the second frequency band, the processor 410 may control the clock generation circuit 420 to apply the drive level having the second value to the XO 321. In response to applying the drive level having the second value to the XO 321, the processor 410 may select the second mapping data among the plurality of mapping data and control the clock generation circuit 420 so that the capacitor (e.g., the capacitor 322 in FIG. 3B) has a capacitance equal to the second correction value included in the selected second mapping data. The processor 410 may transform the second correction value to capacitance value of the capacitor 322 and transmit the capacitance value of the capacitor 322 to the clock generation circuit 420.The clock generation circuit 420 may generate the clock signal having the second reference frequency by correcting the clock signal, which is generated by applying the drive level having the second value to the XO 321, by using the capacitor 322 having the capacitance equal to the second correction value.

According to the embodiment, in response to detecting activation of the third communication method of transmitting and/or receiving data by using the signal in the third frequency band, the processor 410 may control the clock generation circuit 420 to apply the drive level having the third value to the XO 321. In response to applying the drive level having the third value to the XO 321, the processor 410 may select the third mapping data among the plurality of mapping data and control the clock generation circuit 420 so that the capacitor (e.g., the capacitor 322 in FIG. 3B) has a capacitance equal to the third correction value included in the selected third mapping data. The processor 410 may transform the third correction value to capacitance value of the capacitor 322 and transmit the capacitance value of the capacitor 322 to the clock generation circuit 420.The clock generation circuit 420 may generate the clock signal having the third reference frequency by correcting the clock signal, which is generated by applying the drive level having the third value to the XO 321, by using the capacitor 322 having the capacitance equal to the third correction value.

While previous example describes with an assumption that the electronic device 101 may stores a plurality of mapping data including the first mapping data, the second mapping data and the third mapping data. The first mapping data and the second mapping data and the third mapping data may be implemented as a single mapping data. The single mapping data may include the first correction value, the second correction value and the third correction value. The processor 410 may select one of the correction values included in the single mapping data. The clock generation circuit 420 may correct the clock signal using the capacitor 322 having the capacitance equal to the selected correction value.

With the above-mentioned method, the electronic device 101 may correct the clock signal, which is generated by the XO 321, by using different trim values in accordance with the magnitude of the drive level to be applied to the XO 321. Therefore, the electronic device 101 may use the single trim value and generate the clock signal having a relatively low error in comparison with a comparative example in which the highest drive level needs to be applied to the XO 321. The electronic device 101 may increase the lifespan of the XO 321 by reducing the occurrence frequency of the situation in which the highest drive level needs to be applied to the XO 321 in the situation in which the clock signal having the highest reference frequency is not required.

In case that the communication method being used by the electronic device 101 is changed, the processor 410 may identify whether a frequency band used by the changed communication method is a frequency band relatively lower than a frequency band used by the existing communication method. In case that the processor 410 identifies that the frequency band used by the changed communication method is the frequency band relatively lower than the frequency band used by the existing communication method, the processor 410 may control the clock generation circuit 420 to change (or decrease) the magnitude of the drive level to be applied to the XO 321 with reference to the data made by mapping the frequency band stored in the memory 430 and the magnitude of the drive level to be applied to the XO 321. On the basis that the magnitude of the drive level to be applied to the XO 321 is changed (or decreased), the processor 410 may select mapping data mapped with the magnitude of the drive level changed (or decreased) among the plurality of mapping data. The selected mapping data may be mapping data different from the existing selected mapping data. The processor 410 may determine (or change) the correction value with reference to the selected mapping data (or the mapping data different from the existing selected mapping data) and control the clock generation circuit 420 to correct the frequency of the clock signal on the basis of the determined (or changed) correction value.

According to the embodiment, in the state in which the second communication method is activated, the electronic device 101 may deactivate the second communication method and activate the first communication method. The first communication method may be a communication method of transmitting and/or receiving data by using the signal in the first frequency band that is a frequency band of 2.6 GHz or lower. The second communication method may be a communication method of transmitting and/or receiving data by using the signal in the second frequency band that is a frequency band of 6 GHz or higher or an ultrahigh-frequency (e.g., 28 GHz) band. The first frequency band may be a frequency band relatively lower than the second frequency band. The processor 410 may detect the deactivation of the second communication method and the activation of the first communication method and control the clock generation circuit 420 to change (or decrease) the magnitude of the drive level to be applied to the XO 321 from the second value to the first value with reference to the data made by mapping the frequency band and the magnitude of the drive level to be applied to the XO 321. On the basis that the magnitude of the drive level, which is to be applied to the XO 321, is decreased from the second value to the first value, the processor 410 may select the first mapping data that are the mapping data mapped with the reduced magnitude of the drive level among the plurality of mapping data. The selected mapping data may be mapping data different from the second mapping data that are the existing selected mapping data. The processor 410 may determine (or change) the correction value as the first value with reference to the first mapping data that are the selected mapping data, and the processor 410 may control the clock generation circuit 420 to correct the frequency of the clock signal on the basis of the changed correction value.

The processor 410 may detect activation of another communication method in a state in which the communication method being used by the electronic device 101 is kept in the activated state. The processor 410 may determine whether the magnitude of the drive level to be applied to the XO 321 is changed on the basis of a result of comparing the frequency band of the communication method being used and the frequency band being used by the activated communication method. For example, in case that the communication method (e.g., the second communication method), which uses the frequency band (e.g., the second frequency band) higher than the frequency band (e.g., the first frequency band) of the currently used communication method (e.g., the first communication method), is activated, the processor 410 may control the clock generation circuit 420 to change (or increase) the magnitude of the drive level to be applied to the XO 321. For example, in case that the communication method (e.g., the first communication method), which uses the frequency band (e.g., the first frequency band) lower than the frequency band (e.g., the second frequency band) of the currently used communication method (e.g., the second communication method), is activated, the processor 410 may not change the magnitude of the drive level to be applied to the XO 321.

In case that the communication method (e.g., the second communication method), which uses the frequency band (e.g., the second frequency band) higher than the frequency band (e.g., the first frequency band) of the currently used communication method (e.g., the first communication method), is activated, the processor 410 may control the clock generation circuit 420 to change (or increase) the magnitude of the drive level to be applied to the XO 321 with reference to the data made by mapping the frequency band stored in the memory 430 and the magnitude of the drive level to be applied to the XO 321.

On the basis that the magnitude of the drive level to be applied to the XO 321 is changed (or decreased), the processor 410 may select mapping data mapped with the changed (or increased) magnitude of the drive level among the plurality of mapping data. The selected mapping data may be mapping data different from the existing selected mapping data. The processor 410 may determine (or change) the correction value with reference to the selected mapping data (or the mapping data different from the existing selected mapping data) and control the clock generation circuit 420 to correct the frequency of the clock signal on the basis of the determined (or changed) correction value.

On the basis that the magnitude of the drive level to be applied to the XO 321 is not changed (or increased), the processor 410 may control the clock generation circuit 420 to correct the frequency of the clock signal by using the existing selected mapping data.

The example has been described in which the mapping data are made by mapping the magnitude of the drive level and the correction value. However, the mapping data in the present disclosure may not be limited thereto. According to the embodiment, the mapping data may be implemented by mapping the correction value and the control value for adjusting the magnitude of the drive level. The control value may refer to a value applied to the clock generation circuit 420 to allow the processor 410 to control (or change or adjust) the drive level to be applied to the XO 321.

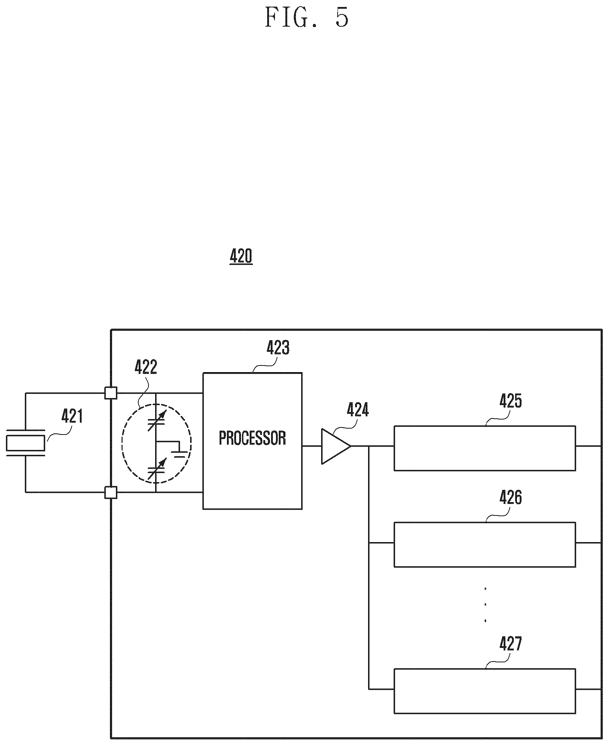

FIG. 5 is a view illustrating an example in which the clock generation circuit corrects the reference frequency by using the plurality of mapping data in the electronic device according to the embodiment.

A clock generation circuit (e.g., the clock generation circuit 420 in FIG. 4) may include an XO 421, at least one capacitor 422, a processor 423, an amplifier 424, and a plurality of frequency change circuits 425, 426, and 427.

The XO 421 may include a crystal element that vibrates at a particular frequency corresponding to a magnitude of a drive level in accordance with a magnitude of a drive level applied by the processor 423. The reference signal may be generated by means of the vibration of the crystal element. The crystal element may change the frequency band related to the vibration of the crystal element depending on the magnitude of the drive level. For example, as the magnitude of the applied drive level increases, the crystal element may greatly vibrate and generate a reference signal having a higher reference frequency.

The processor 423 may generate the clock signal having the reference frequency by applying the drive level, which corresponds to the reference frequency of the clock signal to be generated by the clock generation circuit 420, to the XO 421. However, the XO 421 may generate a clock signal having a frequency different from an accurate reference frequency because of a deviation occurring during a process of producing the XO 421. A difference between the accurate reference frequency and the frequency different from the accurate reference frequency may be defined as a DC frequency error. In order to reduce the error (or generate the clock signal having the accurate reference frequency), the processor 423 may compensate for the clock signal by using the capacitor 422. Specifically, the processor 423 may determine a capacitance of the capacitor 422 that allows the clock signal to have the accurate reference frequency, and the processor 423 may control the capacitor 422 so that the capacitor 422 has the determined capacitance.

The processor 423 may acquire the clock signal having the accurate reference frequency by controlling the capacitor 422. The acquired clock signal may be amplified by the amplifier 424 and transmitted to at least one frequency change circuit among the plurality of frequency change circuits 425, 426, and 427.

The plurality of frequency change circuits 425, 426, and 427 may be electrically connected to the communication circuits (e.g., the first communication circuit 331, the second communication circuit 332, and the third communication circuit 333 in FIG. 3A). The plurality of frequency change circuits 425, 426, and 427 may process the clock signals so that the clock signals have the reference frequencies required for the communication circuits electrically connected to the plurality of frequency change circuits 425, 426, and 427.

According to the embodiment, the plurality of frequency change circuits 425, 426, and 427 may include various components capable of changing the frequencies of the clock signals. The first frequency change circuit 425 may convert the clock signal having the reference frequency into the clock signal having the first reference frequency required for the operation of the first communication circuit 331. The second frequency change circuit 426 may convert the clock signal having the reference frequency into the clock signal having the second reference frequency required for the operation of the second communication circuit 332. The third frequency change circuit 427 may convert the clock signal having the reference frequency into the clock signal having the third reference frequency required for the operation of the third communication circuit 333.

As described above, the processor 423 may control the capacitor 422 to correct the clock signal having a frequency different from the reference frequency because of a deviation of the XO 421 (or to compensate for the frequency of the clock signal). The capacitance, which allows the capacitor 422 to compensate for the frequency, may be defined as a trim.

As described above with reference to FIG. 4, the electronic device 101 corrects the clock signal outputted by the XO 421 by using different trims in accordance with the magnitude of the drive level to be applied to the XO 421, thereby reducing an error in the clock signal and/or reducing the deterioration in lifespan of the XO 421 caused by the consistent application of a high drive level to the XO 421. The electronic device 101 may store, in the memory (e.g., the memory 430 in FIG. 4), a plurality of mapping data made by mapping correction values used to correct the reference frequency of the clock signal in accordance with the magnitude of the drive level to be applied to the XO 421.

The plurality of mapping data may include different correction values in accordance with the magnitude of the drive level to be applied to the XO 421. The plurality of mapping data may include first mapping data including correction values used to correct the clock signal in case that the magnitude of the drive level to be applied to the XO 421 is a first value, second mapping data including correction values used to correct the clock signal in case that the magnitude of the drive level to be applied to the XO 421 is a second value, and third mapping data including correction values used to correct the clock signal in case that the magnitude of the drive level to be applied to the XO 421 is a third value.

The processor 410 may select any one of the plurality of mapping data on the basis of the magnitude of the drive level to be applied to the XO 421.

According to the embodiment, in case that the magnitude of the drive level to be applied to the XO 421 is the first value, the processor 410 may select the first mapping data including the first correction value that is the trim mapped with the first value among the plurality of mapping data.

According to the embodiment, in case that the magnitude of the drive level to be applied to the XO 421 is the second value, the processor 410 may select the second mapping data including the second correction value that is the trim mapped with the second value among the plurality of mapping data.

According to the embodiment, in case that the magnitude of the drive level to be applied to the XO 421 is the third value, the processor 410 may select the third mapping data including the third correction value that is the trim mapped with the third value among the plurality of mapping data.

The example has been described in which the mapping data are implemented by mapping the trim and the magnitude of the drive level to be applied to the XO 421. However, the trim and the communication method used by the electronic device 101 may be mapped. In this case, the plurality of mapping data may be implemented to include different trims (or correction values) in accordance with the communication method used by the electronic device 101. According to the embodiment, the plurality of mapping data may include the first mapping data made by mapping the first communication method and the first correction value, the second mapping data made by mapping the second communication method and the second correction value, and/or the third mapping data made by mapping the third communication method and the third correction value.

The processor 410 may control the clock generation circuit 420 to correct the reference frequency of the clock signal generated by the XO 421 by using the determined correction value with respect to the selected mapping data.

According to the embodiment, in response to detecting activation of the first communication method of transmitting and/or receiving data by using the signal in the first frequency band, the processor 410 may control the clock generation circuit 420 to apply the drive level having the first value to the XO 421. In response to applying the drive level having the first value to the XO 421, the processor 410 may select the first mapping data among the plurality of mapping data and control the clock generation circuit 420 so that the capacitor (e.g., the capacitor 422 in FIG. 3B) has a capacitance equal to the first correction value included in the selected first mapping data. The processor 423, which controls the clock generation circuit 420, may generate the clock signal having the first reference frequency by applying the drive level having the first value to the XO 421 and controlling the capacitor 422 under the control of the processor 410 so that the capacitor 422 has a capacitance equal to the first correction value.

According to the embodiment, in response to detecting activation of the second communication method of transmitting and/or receiving data by using the signal in the second frequency band, the processor 410 may control the clock generation circuit 420 to apply the drive level having the second value to the XO 421. In response to applying the drive level having the second value to the XO 421, the processor 410 may select the second mapping data among the plurality of mapping data and control the clock generation circuit 420 so that the capacitor (e.g., the capacitor 422 in FIG. 3B) has a capacitance equal to the second correction value included in the selected second mapping data. The processor 423, which controls the clock generation circuit 420, may generate the clock signal having the second reference frequency by applying the drive level having the second value to the XO 421 and controlling the capacitor 422 under the control of the processor 410 so that the capacitor 422 has a capacitance equal to the second correction value.

According to the embodiment, in response to detecting activation of the third communication method of transmitting and/or receiving data by using the signal in the third frequency band, the processor 410 may control the clock generation circuit 420 to apply the drive level having the third value to the XO 421. In response to applying the drive level having the third value to the XO 421, the processor 410 may select the third mapping data among the plurality of mapping data and control the clock generation circuit 420 so that the capacitor (e.g., the capacitor 422 in FIG. 3B) has a capacitance equal to the third correction value included in the selected third mapping data. The processor 423, which controls the clock generation circuit 420, may generate the clock signal having the third reference frequency by applying the drive level having the third value to the XO 421 and controlling the capacitor 422 under the control of the processor 410 so that the capacitor 422 has a capacitance equal to the third correction value.

With the above-mentioned method, the electronic device 101 may correct the clock signal, which is generated by the XO 421, by using different trim values in accordance with the magnitude of the drive level to be applied to the XO 421. Therefore, the electronic device 101 may use the single trim value and generate the clock signal having a relatively low error in comparison with a comparative example in which the highest drive level needs to be applied to the XO 421. The electronic device 101 may increase the lifespan of the XO 421 by reducing the occurrence frequency of the situation in which the highest drive level needs to be applied to the XO 421 in the situation in which the clock signal having the highest reference frequency is not required.

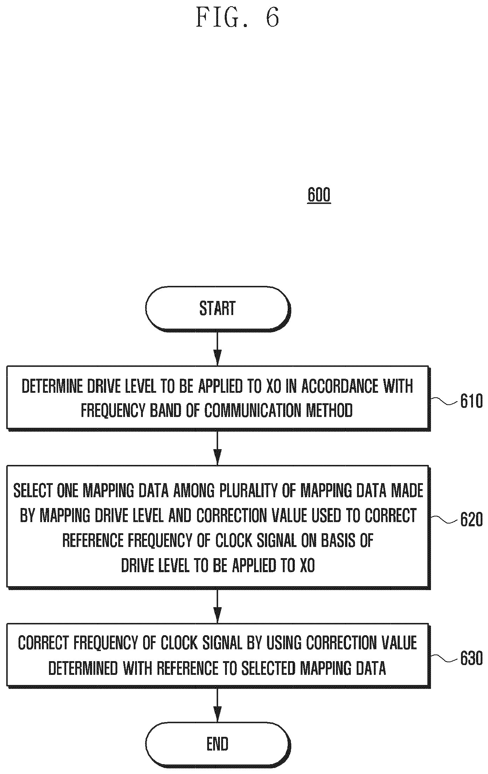

FIG. 6 is a flowchart illustrating a method of operating the electronic device according to the embodiment.

At operation 610, the electronic device (e.g., the electronic device 101 in FIG. 4) may determine the magnitude of the drive level to be applied to the XO (e.g., the XO 421 in FIG. 5) in accordance with the frequency band of the communication method.

The electronic device 101 may identify the frequency band of the communication method being used by the electronic device 101 and control the clock generation circuit 420 to generate the clock signal having the reference frequency included in the identified frequency band.

According to the embodiment, the electronic device 101 may identify the frequency band of the communication method, which is being used by the electronic device 101, by receiving information, which indicates the frequency band of the communication method being used by the electronic device 101, from the communication processor (e.g., the first communication processor 212 or the second communication processor 214 in FIG. 2).

According to the embodiment, the electronic device 101 may identify the frequency band of the communication method, which is being used by the electronic device 101, by receiving information, which indicates the frequency band of the communication method being used by the electronic device 101, from the communication circuit (e.g., the third communication circuit 333 in FIG. 3A) that supports the near field communication.

The electronic device 101 may determine the magnitude of the drive level to be applied to the XO (e.g., the XO 421 in FIG. 5) included in the clock generation circuit 420 on the basis of the identified frequency band. For example, the electronic device 101 may determine the magnitude of the drive level, which is to be applied to the XO 421, with reference to data made by mapping the frequency band and the magnitude of the drive level to be applied to the XO 421.

Alternatively, the electronic device 101 may determine the magnitude of the drive level to be applied to the XO (e.g., the XO 421 in FIG. 3B) included in the clock generation circuit 420 in accordance with the communication method being used by the electronic device 101. For example, the electronic device 101 may determine the magnitude of the drive level to be applied to the XO 421 with reference to data made by mapping the communication method being used by the electronic device 101 and the magnitude of the drive level to be applied to the XO 421.

At operation 620, on the basis of the magnitude of the drive level to be applied to the XO 421, the electronic device 101 may select one mapping data among the plurality of mapping data made by mapping the magnitude of the drive level and the correction value used to correct the reference frequency of the clock signal.

The electronic device 101 corrects the clock signal outputted by the XO 421 by using different trims in accordance with the magnitude of the drive level to be applied to the XO 421, thereby reducing an error in the clock signal and/or reducing the deterioration in lifespan of the XO 421 caused by the consistent application of a high drive level to the XO 421. The electronic device 101 may store, in the memory 430, a plurality of mapping data made by mapping correction values used to correct the reference frequency of the clock signal in accordance with the magnitude of the drive level to be applied to the XO 421.

The plurality of mapping data may include different correction values in accordance with the magnitude of the drive level to be applied to the XO 421. The plurality of mapping data may include the first mapping data including correction values used to correct the clock signal in case that the magnitude of the drive level to be applied to the XO 421 is the first value, the second mapping data including correction values used to correct the clock signal in case that the magnitude of the drive level to be applied to the XO 421 is the second value, and the third mapping data including correction values used to correct the clock signal in case that the magnitude of the drive level to be applied to the XO 421 is the third value.

The electronic device 101 may select any one of the plurality of mapping data on the basis of the magnitude of the drive level to be applied to the XO 421.

According to the embodiment, in case that the magnitude of the drive level to be applied to the XO 421 is the first value, the electronic device 101 may select the first mapping data including the first correction value that is the trim mapped with the first value among the plurality of mapping data.

According to the embodiment, in case that the magnitude of the drive level to be applied to the XO 421 is the second value, the electronic device 101 may select the second mapping data including the second correction value that is the trim mapped with the second value among the plurality of mapping data.

According to the embodiment, in case that the magnitude of the drive level to be applied to the XO 421 is the third value, the electronic device 101 may select the third mapping data including the third correction value that is the trim mapped with the third value among the plurality of mapping data.

The example has been described in which the mapping data are implemented by mapping the trim and the magnitude of the drive level to be applied to the XO 421. However, the trim and the communication method used by the electronic device 101 may be mapped. In this case, the plurality of mapping data may be implemented to include different trims (or correction values) in accordance with the communication method used by the electronic device 101. According to the embodiment, the plurality of mapping data may include the first mapping data made by mapping the first communication method and the first correction value, the second mapping data made by mapping the second communication method and the second correction value, and/or the third mapping data made by mapping the third communication method and the third correction value.

At operation 630, the electronic device 101 may correct the reference frequency of the clock signal by using the correction value determined with reference to the selected mapping data.

The electronic device 101 may control the clock generation circuit 420 to correct the reference frequency of the clock signal generated by the XO 421 by using the determined correction value with respect to the selected mapping data.

According to the embodiment, in response to detecting activation of the first communication method of transmitting and/or receiving data by using the signal in the first frequency band, the electronic device 101 may control the clock generation circuit 420 to apply the drive level having the first value to the XO 421. In response to applying the drive level having the first value to the XO 421, the electronic device 101 may select the first mapping data among the plurality of mapping data and control the clock generation circuit 420 so that the capacitor (e.g., the capacitor 422 in FIG. 3B) has a capacitance equal to the first correction value included in the selected first mapping data. The clock generation circuit 420 may generate the clock signal having the first reference frequency by correcting the clock signal, which is generated by applying the drive level having the first value to the XO 421, by using the capacitor 422 having the capacitance equal to the first correction value.

According to the embodiment, in response to detecting activation of the second communication method of transmitting and/or receiving data by using the signal in the second frequency band, the electronic device 101 may control the clock generation circuit 420 to apply the drive level having the second value to the XO 421. In response to applying the drive level having the second value to the XO 421, the electronic device 101 may select the second mapping data among the plurality of mapping data and control the clock generation circuit 420 so that the capacitor (e.g., the capacitor 422 in FIG. 3B) has a capacitance equal to the second correction value included in the selected second mapping data. The clock generation circuit 420 may generate the clock signal having the second reference frequency by correcting the clock signal, which is generated by applying the drive level having the second value to the XO 421, by using the capacitor 422 having the capacitance equal to the second correction value.

According to the embodiment, in response to detecting activation of the third communication method of transmitting and/or receiving data by using the signal in the third frequency band, the electronic device 101 may control the clock generation circuit 420 to apply the drive level having the third value to the XO 421. In response to applying the drive level having the third value to the XO 421, the electronic device 101 may select the third mapping data among the plurality of mapping data and control the clock generation circuit 420 so that the capacitor (e.g., the capacitor 422 in FIG. 3B) has a capacitance equal to the third correction value included in the selected third mapping data. The clock generation circuit 420 may generate the clock signal having the third reference frequency by correcting the clock signal, which is generated by applying the drive level having the third value to the XO 421, by using the capacitor 422 having the capacitance equal to the third correction value.

With the above-mentioned method, the electronic device 101 may correct the clock signal, which is generated by the XO 421, by using different trim values in accordance with the magnitude of the drive level to be applied to the XO 421. Therefore, the electronic device 101 may use the single trim value and generate the clock signal having a relatively low error in comparison with a comparative example in which the highest drive level needs to be applied to the XO 421. The electronic device 101 may increase the lifespan of the XO 421 by reducing the occurrence frequency of the situation in which the highest drive level needs to be applied to the XO 421 in the situation in which the clock signal having the highest reference frequency is not required.

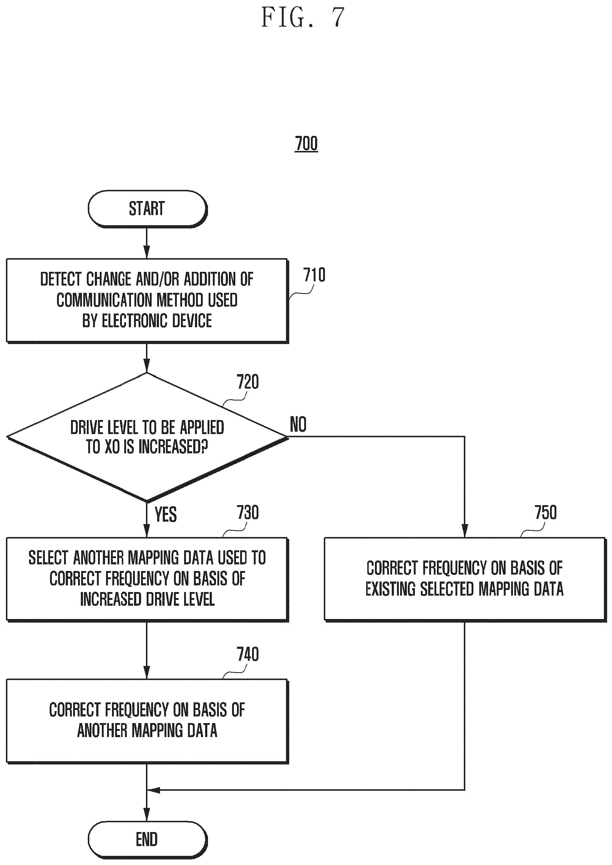

FIG. 7 is a flowchart illustrating the method of operating the electronic device according to the embodiment.

At operation 710, the electronic device (e.g., the electronic device 101 in FIG. 4) may detect the change and/or addition of the communication method used by the electronic device 101.

The change of the communication method used by the electronic device 101 may mean that the currently activated communication method switches to the deactivated state and another communication method is activated. The addition of the communication method used by the electronic device 101 may mean that the currently activated communication method is kept in the activated state and another communication method is activated.

At operation 720, the electronic device 101 may identify whether the magnitude of the drive level to be applied to the XO (e.g., the XO 421 in FIG. 4) increases.

The electronic device 101 may determine whether the magnitude of the drive level to be applied to the XO 421 is changed on the basis of a result of comparing the frequency band of the communication method being used and the frequency band being used by the activated communication method. For example, in case that the communication method (e.g., the second communication method), which uses the frequency band (e.g., the second frequency band) higher than the frequency band (e.g., the first frequency band) of the currently used communication method (e.g., the first communication method), is activated, the electronic device 101 may control the clock generation circuit 420 to change (or increase) the magnitude of the drive level to be applied to the XO 421. For example, in case that the communication method (e.g., the first communication method), which uses the frequency band (e.g., the first frequency band) lower than the frequency band (e.g., the second frequency band) of the currently used communication method (e.g., the second communication method), is activated, the electronic device 101 may not change the magnitude of the drive level to be applied to the XO 421.

In case that the communication method (e.g., the second communication method), which uses the frequency band (e.g., the second frequency band) higher than the frequency band (e.g., the first frequency band) of the currently used communication method (e.g., the first communication method), is activated, the electronic device 101 may control the clock generation circuit 420 to change (or increase) the magnitude of the drive level to be applied to the XO 421 with reference to the data made by mapping the frequency band stored in the memory 430 and the magnitude of the drive level to be applied to the XO 421.

At operation 730, in response to the increase in the magnitude of the drive level to be applied to the XO 421 (operation 720-Y), the electronic device 101 may select another mapping data, which are to be used to correct the frequency of the clock signal, on the basis of the increased magnitude of the drive level.

On the basis that the magnitude of the drive level to be applied to the XO 421 is changed (or increased), the electronic device 101 may select mapping data mapped with the changed (or increased) magnitude of the drive level among the plurality of mapping data. The selected mapping data may be mapping data different from the existing selected mapping data.

Based on the magnitude of drive level to be applied to the XO 421 is decreased, the electronic device 101 may select mapping data mapped with the decreased magnitude of the drive level among the plurality of mapping data. The selected mapping data may be mapping data different from the existing selected mapping data.

At operation 740, the electronic device 101 may correct the frequency of the clock signal on the basis of another mapping data.

The electronic device 101 may determine (or change) the correction value with reference to the selected mapping data (or the mapping data different from the existing selected mapping data) and control the clock generation circuit 420 to correct the frequency of the clock signal on the basis of the determined (or changed) correction value.

At operation 750, on the basis that the magnitude of the drive level to be applied to the XO 421 is not increased (operation 720-N), the electronic device 101 may correct the clock signal on the basis of the existing selected mapping data.

On the basis that the magnitude of the drive level to be applied to the XO 421 is not changed (or increased), the electronic device 101 may control the clock generation circuit 420 to correct the frequency of the clock signal by using the existing selected mapping data.

An electronic device according to an embodiment includes a processor. The electronic device may include a clock generation circuit including a crystal oscillator (XO) configured to generate a clock signal having at least one of a plurality of reference frequencies. The electronic device may include a memory configured to store a plurality of mapping data, which is made by mapping correction values used to correct the reference frequency of the clock signal, in accordance with a control value of a drive level for controlling a drive level to be applied to the XO or a magnitude of the drive level. The processor may select the control value of the drive level to be applied to the XO in accordance with a frequency band of a communication method used by the electronic device. The processor may select one of the plurality of mapping data on the basis of the control value of the drive level. The processor may be configured to control the clock generation circuit to correct the reference frequency of the clock signal by using the correction value determined with reference to the selected mapping data.

In the electronic device according to the embodiment, the plurality of mapping data may be configured to include different correction values in accordance with the magnitude of the drive level to be applied to the XO.

In the electronic device according to the embodiment, the plurality of mapping data may be configured to include different correction values in accordance with the communication method used by the electronic device.

In the electronic device according to the embodiment, the processor may be configured to control the clock generation circuit so that drive levels with different magnitudes are applied to the XO in accordance with the frequency band of the communication used by the electronic device.

In the electronic device according to the embodiment, the processor may control the clock generation circuit to decrease the magnitude of the drive level to be applied to the XO when the frequency band of the communication used by the electronic device decreases. The processor may select another mapping data from the plurality of mapping data on the basis of the decreased magnitude of the drive level. The processor may be configured to control the clock generation circuit to correct the reference frequency of the clock signal on the basis of the correction value determined with reference to another mapping data.

In the electronic device according to the embodiment, the processor may select another mapping data from the plurality of mapping data on the basis that a change in the magnitude of the drive level to be applied to the XO in accordance with activation of another communication method is identified. The processor may be configured to control the clock generation circuit to correct the reference frequency of the clock signal on the basis of the correction value determined with reference to another mapping data.

In the electronic device according to the embodiment, the processor may be configured to select another mapping data from the plurality of mapping data when the magnitude of the drive level to be applied to the XO increases.

In the electronic device according to the embodiment, the processor may be configured to control the clock generation circuit to correct the reference frequency of the clock signal by using the correction value determined with reference to the selected mapping data without selecting another mapping data when the magnitude of the drive level to be applied to the XO decreases.

In the electronic device according to the embodiment, the number of mapping data may be equal to the number of magnitudes of the drive levels to be applied to the XO.

In the electronic device according to the embodiment, the plurality of mapping data may include first mapping data including correction values used to correct a clock signal having a reference frequency of 20 to 100 GHz. The plurality of mapping data may include second mapping data including correction values used to correct a clock signal having a reference frequency of 3 GHz or lower.

A method of operating an electronic device according to the embodiment may include determining a control value of a drive level to be applied to a crystal oscillator (XO) configured to generate a clock signal having at least one of a plurality of reference frequencies in accordance with a frequency band of a communication method used by the electronic device. The method of operating the electronic device may include selecting one of a plurality of mapping data, which is made by mapping correction values used to correct the reference frequency of the clock signal and a magnitude of the drive level to be applied to the XO, on the basis of a control value of the drive level to be applied to the XO. The method of operating the electronic device may include correcting the reference frequency of the clock signal by using the correction value determined with reference to the selected mapping data.

In the method of operating the electronic device according to the embodiment, the plurality of mapping data may be configured to include different correction values in accordance with the magnitude of the drive level to be applied to the XO.

In the method of operating the electronic device according to the embodiment, the plurality of mapping data may be configured to include different correction values in accordance with the communication method used by the electronic device.

In the method of operating the electronic device according to the embodiment, the determining of the magnitude of the drive level to be applied to the XO may include determining the magnitude of the drive level so that drive levels with different magnitudes are applied to the XO in accordance with the frequency band of the communication used by the electronic device.

The method of operating the electronic device according to the embodiment may further include decreasing the magnitude of the drive level to be applied to the XO when the frequency band of the communication used by the electronic device decreases. The method of operating the electronic device may further include selecting another mapping data from the plurality of mapping data on the basis of the decreased magnitude of the drive level. The method of operating the electronic device may further include correcting the reference frequency of the clock signal on the basis of the correction value determined with reference to another mapping data.

The method of operating the electronic device according to the embodiment may further include selecting another mapping data from the plurality of mapping data on the basis that a change in the magnitude of the drive level to be applied to the XO in accordance with activation of another communication method is identified. The method of operating the electronic device may further include correcting the reference frequency of the clock signal on the basis of the correction value determined with reference to another mapping data.

The method of operating the electronic device according to the embodiment may further include selecting another mapping data from the plurality of mapping data when the magnitude of the drive level to be applied to the XO increases.

The method of operating the electronic device according to the embodiment may further include correcting the reference frequency of the clock signal by using the correction value determined with reference to the selected mapping data without selecting another mapping data when the magnitude of the drive level to be applied to the XO decreases.

In the method of operating the electronic device according to the embodiment, the number of mapping data may be equal to the number of magnitudes of the drive levels to be applied to the XO.

In the method of operating the electronic device according to the embodiment, the plurality of mapping data may include

first mapping data including correction values used to correct a clock signal having a reference frequency of 20 to 100 GHz. The plurality of mapping data may include second mapping data including correction values used to correct a clock signal having a reference frequency of 3 GHz or lower.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor(e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a processor;
a clock generation circuit (320) comprising a crystal oscillator, XO, (321) configured to generate a clock signal having at least one of a plurality of reference frequencies; and
memory (130) configured to store mapping data in which each of correction values used to correct the reference frequency of the clock signal are mapped with each of drive levels to be applied to the XO and another mapping data including different correction values in accordance with a communication method used by the electronic device,
wherein the processor is configured to:
select the drive level to be applied to the XO corresponding to a frequency band of the communication method used by the electronic device;
select the correction value that corresponds with the selected drive level based on the mapping data and the other mapping data; and
control the clock generation circuit (320) to correct the reference frequency of the clock signal by using the selected correction value.

2. The electronic device (101) of claim 1, wherein the mapping data includes different correction values corresponding to each of the drive levels to be applied to the XO (321).

3. The electronic device (101) of claim 1, wherein the processor is configured to control the clock generation circuit (320) so that drive levels with different magnitudes are applied to the XO (321) based on the frequency band of the communication used by the electronic device.

4. The electronic device (101) of claim 1, wherein the processor is configured to:
control the clock generation circuit (320) to decrease a magnitude of the drive level to be applied to the XO (321) when the frequency band of the communication method used by the electronic device decreases;
select another correction value among the correction values included in the mapping data based on the decreased magnitude of the drive level; and
control the clock generation circuit (320) to correct the reference frequency of the clock signal based on the selected another correction value.

5. The electronic device (101) of claim 1, wherein the processor is configured to:
select another correction value among the correction values included in the mapping data when a change in a magnitude of the drive level to be applied to the XO (321) in accordance with activation of another communication method is identified; and
control the clock generation circuit (320) to correct the reference frequency of the clock signal based on the selected another correction value.

6. The electronic device (101) of claim 5, wherein the processor is configured to select another correction value when a magnitude of the drive level to be applied to the XO (321) increases.

7. The electronic device (101) of claim 5, wherein the processor is configured to control the clock generation circuit (320) to correct the reference frequency of the clock signal by using the correction value when a magnitude of the drive level to be applied to the XO (321) decreases.

8. The electronic device (101) of claim 1, wherein the number of correction values is equal to the number of the drive levels to be applied to the XO (321).

9. The electronic device (101) of claim 1, wherein the correction values comprise:
a first correction value used to correct a clock signal having a reference frequency of 20 to 100 GHz; and
a second correction value used to correct a clock signal having a reference frequency of 3 GHz or lower.

10. A method of operating an electronic device (101), the method comprising:
determining a drive level to be applied to a crystal oscillator, XO, (321) configured to generate a clock signal having at least one of a plurality of reference frequencies based on a frequency band of a communication method used by the electronic device;
selecting a correction value that corresponds with the determined drive level based on mapping data in which correction values used to correct the reference frequency of the clock signal are mapped to each of drive levels to be applied to the XO and based on another mapping data including different correction values in accordance with the communication method used by the electronic device; and
correcting the reference frequency of the clock signal by using the selected correction value.

11. The method of claim 10, wherein the mapping data includes different correction values corresponding to each of the drive levels to be applied to the XO (321).

12. The method of claim 10, wherein the determining the drive level to be applied to the XO (321) comprises:
determining the drive level so that drive levels with different magnitudes are applied to the XO corresponding to the frequency band of the communication method used by the electronic device.

13. The method of claim 10, further comprising:
decreasing a magnitude of the drive level to be applied to the XO (321) when the frequency band of the communication used by the electronic device decreases;
selecting another correction value from the mapping data based on the decreased magnitude of the drive level; and
correcting the reference frequency of the clock signal based on the correction value.

## Patentansprüche

1. Elektronische Vorrichtung (101), die Folgendes umfasst:
einen Prozessor;
eine Takterzeugungsschaltung (320), die einen Kristalloszillator (XO) (321) umfasst, der konfiguriert ist, um ein Taktsignal zu erzeugen, das zumindest eine aus einer Vielzahl von Referenzfrequenzen aufweist; und
einen Speicher (130), der konfiguriert ist, um Abbildungsdaten zu speichern, in denen jeder von Korrekturwerten, die verwendet werden, um die Referenzfrequenz des Taktsignals zu korrigieren, auf jeden von an den XO anzulegenden Ansteuerungspegeln abgebildet werden, und um andere Abbildungsdaten zu speichern, die unterschiedliche Korrekturwerte in Übereinstimmung mit einem von der elektronischen Vorrichtung verwendeten Kommunikationsverfahren enthalten, wobei der Prozessor zu Folgendem konfiguriert ist:
Auswählen des an den XO anzulegenden Ansteuerungspegels, der einem Frequenzband des von der elektronischen Vorrichtung verwendeten Kommunikationsverfahrens entspricht;
Auswählen des Korrekturwerts, der dem ausgewählten Ansteuerungspegel entspricht, basierend auf den Abbildungsdaten und den anderen Abbildungsdaten; und
Steuern der Takterzeugungsschaltung (320), um die Referenzfrequenz des Taktsignals unter Verwendung des ausgewählten Korrekturwerts zu korrigieren.

2. Elektronische Vorrichtung (101) nach Anspruch 1, wobei die Abbildungsdaten unterschiedliche Korrekturwerte einschließen, die jedem der an den XO (321) anzulegenden Ansteuerungspegel entsprechen.

3. Elektronische Vorrichtung (101) nach Anspruch 1, wobei der Prozessor konfiguriert ist, um die Takterzeugungsschaltung (320) so zu steuern, dass auf der Basis des Frequenzbandes der von der elektronischen Vorrichtung verwendeten Kommunikation Ansteuerungspegel mit unterschiedlichen Größen an den XO (321) angelegt werden.

4. Elektronische Vorrichtung (101) nach Anspruch 1, wobei der Prozessor zu Folgendem konfiguriert ist:
Steuern der Takterzeugungsschaltung (320), um eine Größe des an den XO (321) anzulegenden Ansteuerungspegels zu verringern, wenn sich das Frequenzband des von der elektronischen Vorrichtung verwendeten Kommunikationsverfahrens verringert;
Auswählen eines anderen Korrekturwertes unter den in den Abbildungsdaten enthaltenen Korrekturwerten basierend auf der verringerten Größe des Ansteuerungspegels; und
Steuern der Takterzeugungsschaltung (320), um die Referenzfrequenz des Taktsignals basierend auf dem ausgewählten anderen Korrekturwert zu korrigieren.

5. Elektronische Vorrichtung (101) nach Anspruch 1, wobei der Prozessor zu Folgendem konfiguriert ist:
Auswählen eines anderen Korrekturwerts unter den in den Abbildungsdaten enthaltenen Korrekturwerten, wenn eine Änderung einer Größe des an den XO (321) anzulegenden Ansteuerungspegels in Übereinstimmung mit der Aktivierung eines anderen Kommunikationsverfahrens identifiziert wird; und
Steuern der Takterzeugungsschaltung (320), um die Referenzfrequenz des Taktsignals basierend auf dem ausgewählten anderen Korrekturwert zu korrigieren.

6. Elektronische Vorrichtung (101) nach Anspruch 5, wobei der Prozessor konfiguriert ist, um einen anderen Korrekturwert auszuwählen, wenn eine Größe des an den XO (321) anzulegenden Ansteuerungspegels zunimmt.

7. Elektronische Vorrichtung (101) nach Anspruch 5, wobei der Prozessor konfiguriert ist, um die Takterzeugungsschaltung (320) so zu steuern, dass sie die Referenzfrequenz des Taktsignals unter Verwendung des Korrekturwerts korrigiert, wenn eine Größe des an den XO (321) anzulegenden Ansteuerungspegels abnimmt.

8. Elektronische Vorrichtung (101) nach Anspruch 1, wobei die Anzahl der Korrekturwerte gleich der Anzahl der an den XO (321) anzulegenden Ansteuerungspegel ist.

9. Elektronische Vorrichtung (101) nach Anspruch 1, wobei die Korrekturwerte Folgendes umfassen:
einen ersten Korrekturwert, der verwendet wird, um ein Taktsignal zu korrigieren, das eine Referenzfrequenz von 20 bis 100 GHz aufweist; und
einen zweiten Korrekturwert, der verwendet wird, um ein Taktsignal zu korrigieren, das eine Referenzfrequenz von 3 GHz oder weniger aufweist.

10. Verfahren zur Bedienung einer elektronischen Vorrichtung (101), wobei das Verfahren Folgendes umfasst:
Bestimmen eines an einen Kristalloszillator (XO) (321) anzulegenden Ansteuerungspegels, der konfiguriert ist, um ein zumindest eine von einer Vielzahl von Referenzfrequenzen aufweisendes Taktsignal zu erzeugen, und zwar basierend auf einem Frequenzband eines von der elektronischen Vorrichtung verwendeten Kommunikationsverfahrens;
Auswählen eines Korrekturwerts, der dem bestimmten Ansteuerungspegel entspricht, basierend auf Abbildungsdaten, in denen Korrekturwerte, die verwendet werden, um die Referenzfrequenz des Taktsignals zu korrigieren, auf jeden von Ansteuerungspegeln abgebildet werden, die an den XO anzulegen sind, und basierend auf anderen Abbildungsdaten, die unterschiedliche Korrekturwerte in Übereinstimmung mit dem von der elektronischen Vorrichtung verwendeten Kommunikationsverfahren enthalten; und
Korrigieren der Referenzfrequenz des Taktsignals unter Verwendung des ausgewählten Korrekturwerts.

11. Verfahren nach Anspruch 10, wobei die Abbildungsdaten unterschiedliche Korrekturwerte einschließen, die jedem der an den XO (321) anzulegenden Ansteuerungspegel entsprechen.

12. Verfahren nach Anspruch 10, wobei das Bestimmen des an den XO (321) anzulegenden Ansteuerungspegels Folgendes umfasst:
Bestimmen des Ansteuerungspegels, so dass Ansteuerungspegel mit unterschiedlichen Größen an den XO angelegt werden, die dem Frequenzband des von der elektronischen Vorrichtung verwendeten Kommunikationsverfahrens entsprechen.

13. Verfahren nach Anspruch 10, das ferner Folgendes umfasst:
Verringern einer Größe des an den XO (321) anzulegenden Ansteuerungspegels, wenn sich das Frequenzband der von der elektronischen Vorrichtung verwendeten Kommunikation verringert;
Auswählen eines anderen Korrekturwertes aus den Abbildungsdaten basierend auf der verringerten Größe des Ansteuerungspegels; und
Korrigieren der Referenzfrequenz des Taktsignals basierend auf dem Korrekturwert.

## Revendications

1. Dispositif électronique (101) comprenant :
un processeur,
un circuit de génération d'horloge (320) comprenant un oscillateur à cristal (dit « XO ») (321) conçu pour générer un signal d'horloge ayant au moins une fréquence parmi une pluralité de fréquences de référence, et
une mémoire (130) conçue pour le stockage de données de mappage dans lesquelles chaque valeur de correction servant à corriger la fréquence de référence du signal d'horloge est mappée sur chaque niveau de pilotage à appliquer à l'XO, et d'autres données de mappage comprenant différentes valeurs de correction conformes à un procédé de communication utilisé par le dispositif électronique,
le processeur étant conçu pour :
sélectionner le niveau de pilotage à appliquer à l'XO en correspondance avec la bande de fréquence du procédé de communication utilisé par le dispositif électronique ;
sélectionner la valeur de correction qui correspond au niveau de pilotage sélectionné, en fonction des données de mappage et des autres données de mappage ; et
commander le circuit de génération d'horloge (320) de façon à corriger la fréquence de référence du signal d'horloge au moyen de la valeur de correction sélectionnée.

2. Dispositif électronique (101) selon la revendication 1, dans lequel les données de mappage comprennent différentes valeurs de correction correspondant à chacun des niveaux de pilotage à appliquer à l'XO (321).

3. Dispositif électronique (101) selon la revendication 1, dans lequel le processeur est conçu pour commander le circuit de génération d'horloge (320) de façon que des niveaux de pilotage de différentes grandeurs soient appliqués à l'XO (321) en fonction de la bande de fréquence de la communication utilisée par le dispositif électronique.

4. Dispositif électronique (101) selon la revendication 1, dans lequel le processeur est conçu pour :
commander le circuit de génération d'horloge (320) de façon à réduire la grandeur du niveau de pilotage à appliquer à l'XO (321) lorsque la bande de fréquence du procédé de communication utilisé par le dispositif électronique diminue,
sélectionner une autre valeur de correction parmi les valeurs de correction présentes dans les données de mappage en fonction de la réduction de la grandeur du niveau de pilotage, et
commander le circuit de génération d'horloge (320) de façon à corriger la fréquence de référence du signal d'horloge en fonction de ladite autre valeur de correction sélectionnée.

5. Dispositif électronique (101) selon la revendication 1, dans lequel le processeur est conçu pour :
sélectionner une autre valeur de correction parmi les valeurs de correction présentes dans les données de mappage lorsqu'un changement de grandeur du niveau de pilotage à appliquer à l'XO (321) conformément à l'activation d'un autre procédé de communication est identifié, et
commander le circuit de génération d'horloge (320) de façon à corriger la fréquence de référence du signal d'horloge en fonction de ladite autre valeur de correction sélectionnée.

6. Dispositif électronique (101) selon la revendication 5, dans lequel le processeur est conçu pour sélectionner une autre valeur de correction lorsque la grandeur du niveau de pilotage à appliquer à l'XO (321) augmente.

7. Dispositif électronique (101) selon la revendication 5, dans lequel le processeur est conçu pour commander le circuit de génération d'horloge (320) de façon à corriger la fréquence de référence du signal d'horloge au moyen de la valeur de correction lorsque la grandeur du niveau de pilotage à appliquer à l'XO (321) diminue.

8. Dispositif électronique (101) selon la revendication 1, dans lequel le nombre de valeurs de correction est égal au nombre de niveaux de pilotage à appliquer à l'XO (321).

9. Dispositif électronique (101) selon la revendication 1, dans lequel les valeurs de correction comprennent :
une première valeur de correction servant à corriger un signal d'horloge ayant une fréquence de référence de 20 à 100 GHz, et
une deuxième valeur de correction servant à corriger un signal d'horloge ayant une fréquence de référence de 3 GHz ou moins.

10. Procédé d'exploitation d'un dispositif électronique (101), le procédé comprenant :
la détermination d'un niveau de pilotage à appliquer à un oscillateur à cristal (dit « XO ») (321), conçu pour générer un signal d'horloge ayant au moins une fréquence parmi de multiples fréquences de référence, compte tenu de la bande de fréquence d'un procédé de communication utilisé par le dispositif électronique ;
la sélection d'une valeur de correction qui correspond au niveau de pilotage déterminé, en fonction de données de mappage dans lesquelles chaque valeur de correction servant à corriger la fréquence de référence du signal d'horloge est mappée sur chaque niveau de pilotage à appliquer à l'XO, et en fonction d'autres données de mappage comprenant différentes valeurs de correction conformes au procédé de communication utilisé par le dispositif électronique ; et
la correction de la fréquence de référence du signal d'horloge au moyen de la valeur de correction sélectionnée.

11. Procédé selon la revendication 10, dans lequel les données de mappage comprennent différentes valeurs de correction correspondant à chacun des niveaux de pilotage à appliquer à l'XO (321).

12. Procédé selon la revendication 10, dans lequel la détermination du niveau de pilotage à appliquer à l'XO (321) comprend :
la détermination du niveau de pilotage de façon que des niveaux de pilotage de grandeurs différentes soient appliqués à l'XO en correspondance avec la bande de fréquence du procédé de communication utilisé par le dispositif électronique.

13. Procédé selon la revendication 10, comprenant en outre :
la réduction de la grandeur du niveau de pilotage à appliquer à l'XO (321) lorsque la bande de fréquence de la communication utilisée par le dispositif électronique diminue,
la sélection d'une autre valeur de correction parmi les données de mappage en fonction de la réduction de la grandeur du niveau de pilotage, et
la correction de la fréquence de référence du signal d'horloge en fonction de la valeur de correction.
